(19)

Europäisches
Patentamt
European
Patent Office
Office européen
des brevets

(11) **EP 3 072 991 A1**

(12) **EUROPEAN PATENT APPLICATION**
published in accordance with Art. 153(4) EPC

(43) Date of publication:
**28.09.2016 Bulletin 2016/39**

(21) Application number: **14863221.9**

(22) Date of filing: **14.11.2014**

(51) Int Cl.:
**C23C 16/40** [(2006.01)]     **C03C 17/245** [(2006.01)]

(86) International application number:
**PCT/JP2014/080253**

(87) International publication number:
**WO 2015/076210 (28.05.2015 Gazette 2015/21)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **19.11.2013   JP 2013238795
01.04.2014   JP 2014075636**

(71) Applicant: **Asahi Glass Company, Limited
Tokyo 100-8405 (JP)**

(72) Inventors:
• **MATSUI, Yuji**
  **Tokyo 100-8405 (JP)**
• **USUI, Reo**
  **Tokyo 100-8405 (JP)**
• **SEKI, Atsushi**
  **Tokyo 100-8405 (JP)**
• **IWAOKA, Hiroaki**
  **Tokyo 100-8405 (JP)**

(74) Representative: **Müller-Boré & Partner
Patentanwälte PartG mbB
Friedenheimer Brücke 21
80639 München (DE)**

(54) **THIN FILM FORMATION METHOD AND COATED GLASS**

(57)     The present invention relates to a method for forming a $TiO_2$ thin film by using an atmospheric pressure CVD method, on an $SnO_2$ thin film formed on/above a substrate, in which a raw material gas contains titanium tetraisopropoxide (TTIP) and a tin chloride and the amount of the tin chloride is from 0.02 to 0.1 as a concentration ratio to the titanium tetraisopropoxide (TTIP) (tin chloride (mol%)/TTIP (mol%)).

**EP 3 072 991 A1**

**Description**

Technical Field

The present invention relates to a thin film formation method and a coated glass. Specifically, it relates to a method for forming a thin film composed of titanium oxide ($TiO_2$) as a main component (hereinafter referred to as "$TiO_2$ thin film") on a substrate by using an atmospheric pressure CVD method, and a coated glass obtained by the method. Moreover, the present invention also relates to a coated glass in which an $SnO_2$ thin film and a $TiO_2$ thin film are formed on/above a glass substrate in this order.

The $TiO_2$ thin film to be formed by the method of the present invention is, at the time of producing a thin film-type solar cell, suitable as various functional films to be formed on/above a substrate (e.g., a glass substrate) constituting a transparent substrate of the thin film-type solar cell, specifically as an alkali barrier layer and as an intermediate refractive index layer formed between the glass substrate and a tin oxide film constituting a transparent conductive film.

Moreover, the $TiO_2$ thin film to be formed by the method of the present invention is also suitable as various functional films to be formed on/above a substrate for the other use applications, specifically as a layer constituting a part of an antireflection film, as a surface layer for Low-E (Low-emissivity) glass that is excellent in heat insulation effect and as a reflection amplifying layer of a sunlight collecting glass.

Background Art

As mentioned above, a $TiO_2$ thin film may be formed on/above a substrate for various purposes, and a method of forming a $TiO_2$ thin film on a substrate by an atmospheric pressure CVD method has been proposed.

In the case where a $TiO_2$ thin film is formed as a layer constituting a part of an antireflection film, a silicone oxide ($SiO_2$) thin film as a low refractive index film having a refractive index lower than that of Ti02 and the $TiO_2$ thin film are alternately laminated. Here, in the case where the $SiO_2$ thin film and the $TiO_2$ thin film are formed by using the atmospheric pressure CVD method, the deposition rates of these thin films are desired to be high from the viewpoint of an improvement in productivity. Also in the aforementioned other use applications, the deposition rate at the time of $TiO_2$ thin film formation by the atmospheric pressure CVD method is desired to be high from the viewpoint of an improvement in productivity.

Furthermore, for example, Patent Document 1 discloses a method for forming a thin film of tin-containing titanium oxide, which exhibits a photocatalytic activity, mainly by a CVD method in a float bath while adding highly reactive titanium chloride as a main raw material and an ester or the like as an oxygen source.

On the other hand, Patent Document 2 discloses Low-E glass in which light reflectance is improved and thereby a heat insulation effect is enhanced by forming an outer reflective layer having a refractive index ranging from 2.0 to 2.8 on a main layer containing tin oxide ($SnO_2$) or antimony oxide ($Sb_2O_3$) on a glass substrate. As the outer reflective layer, titanium oxide ($TiO_2$) is preferred since it affords high luminous reflectance at an extremely thin coating thickness.

Prior Art Documents

Patent Documents

Patent Document 1: JP-T-2004-507430
Patent Document 2: JP-T-2002-509516

Summary of the Invention

Problems that the Invention is to Solve

However, since titanium chloride is highly reactive with water, there has been a problem that handling thereof in the air atmosphere is difficult. On the other hand, when a raw material other than titanium chloride, e.g., titanium tetraisopropoxide (TTIP) is used, its reactivity is not high as compared with titanium chloride, so that there has been a problem that it is difficult to secure deposition rate.

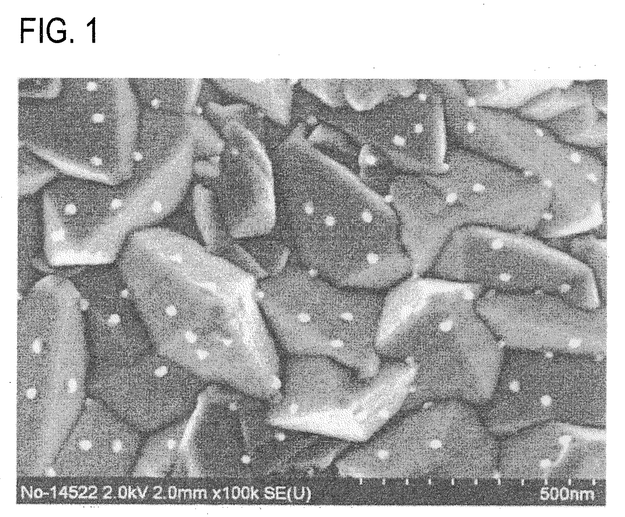

Moreover, it is known that in the case of using TTIP as a raw material, a $TiO_2$ thin film to be formed is affected by surface properties of a substrate. For example, since growth nuclear density of $TiO_2$ extremely decreases on a tin oxide ($SnO_2$) film surface composed of crystal grains, $TiO_2$ grows in an island shape. FIG. 1 is a scanning electron microscope (SEM) photograph of a tin oxide ($SnO_2$) film surface on which $TiO_2$ is formed by using TTIP as a raw material (Source: Japan Domestic Re-publication of PCT Patent Application 2011-013719). In FIG. 1, those shown as lumps are crystal grains of tin oxide ($SnO_2$) and those distributed in a white-dot shape are $TiO_2$.

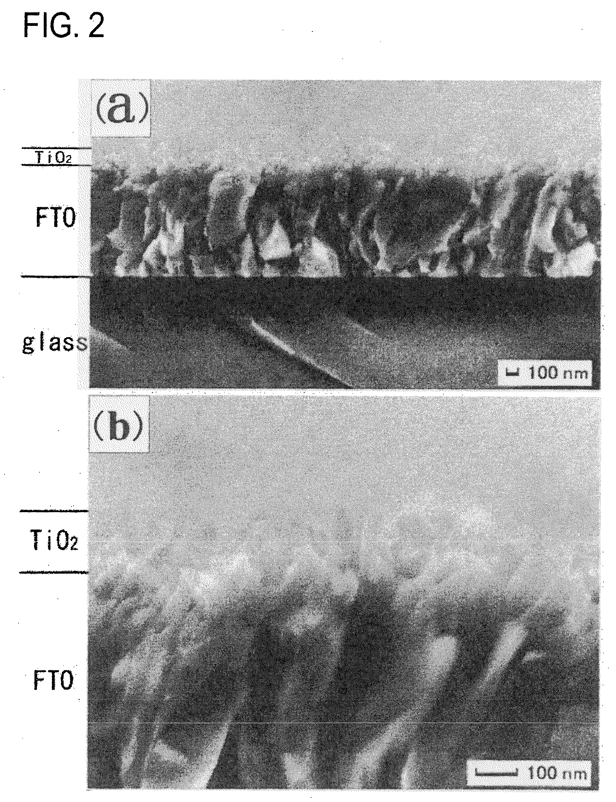

When a $TiO_2$ thin film is formed on a tin oxide ($SnO_2$) film surface composed of crystal grains, the $TiO_2$ thin film to be formed is prone to have a low density structure due to being constituted by a fine crystal grains of $TiO_2$. FIG. 2(a) is a cross-sectional SEM photograph of a fluorine-doped tin oxide ($SnO_2$) (FTO) film where a $TiO_2$ thin film is formed on the surface and FIG. 2(b) is an enlarged view of the site where the $TiO_2$ thin film is formed (Source: Yoshitake Masuda and Kazumi Kato, Chem. Mater. 2008, 20, 1057-1063).

When a $TiO_2$ thin film to be formed is densified, refractive index of the $TiO_2$ thin film is increased. It is considered that visible light optical reflectance (Rv) is thereby increased. The increase in the visible light optical reflectance (Rv) improves a shading effect in the case of the use as Low-E glass. Therefore, the densification of the $TiO_2$ thin film to be formed is desirable. Moreover, by densifying the $TiO_2$ thin film, durability against deformation of the film structure by mechanical contact is also improved. For example, in the case where a geometrical thickness of the $TiO_2$ layer is decreased by pressing, reflection color tone only in the pressed portion is changed. In the case of the use as Low-E glass for construction, it is a fetal problem that uniformity of appearance is impaired by such color tone change.

In order to solve the problems in the aforementioned conventional art, an object of the present invention is to improve the deposition rate at the time of forming a $TiO_2$ thin film on a substrate by using an atmospheric pressure CVD method.

Means for Solving the Problems

In order to solve the above problem, the present inventors have conducted extensive studies and as a result, have found that the deposition rate can be improved without deteriorating optical properties of the $TiO_2$ thin film by using a specific raw material, specifically titanium tetraisopropoxide (TTIP) as a Ti raw material to be used at the time of $TiO_2$ thin film formation by an atmospheric pressure CVD method and by adding, as an auxiliary raw material, a minute amount of a metal chloride vaporizable under conditions for performing the atmospheric pressure CVD.

The present invention has been made based on the above findings and provides a method for forming a $TiO_2$ thin film by using an atmospheric pressure CVD method, on an $SnO_2$ thin film formed on/above a substrate, in which a raw material gas contains titanium tetraisopropoxide (TTIP) and a tin chloride and the amount of the tin chloride is from 0.02 to 0.1 as a concentration ratio to the titanium tetraisopropoxide (TTIP) (tin chloride (mol%)/TTIP (mol%)).

In the method for forming a $TiO_2$ thin film of the present invention, the amount of the tin chloride is preferably from 0.025 to 0.08 as a concentration ratio to the titanium tetraisopropoxide (TTIP) (tin chloride (mol%)/TTIP (mol%)).

In the method for forming a $TiO_2$ thin film of the present invention, the tin chloride is preferably monobutyltin trichloride (MBTC) or tin tetrachloride ($SnCl_4$).

In the method for forming a $TiO_2$ thin film of the present invention, it is preferred that the substrate is a glass substrate and the substrate has a temperature of from 520 to 600°C at the time of forming the $TiO_2$ thin film.

In the method for forming a $TiO_2$ thin film of the present invention, the $SnO_2$ thin film may contain fluorine (F) or antimony (Sb) as a dopant.

In the method for forming a $TiO_2$ thin film of the present invention, an $SiO_x$ ($0<x\leq2$) thin film may be formed between the substrate and the $SnO_2$ thin film.

Moreover, the present invention provides a coated glass obtained by the method for forming a $TiO_2$ thin film of the present invention, in which an $SnO_2$ thin film and a $TiO_2$ thin film are formed on/above a glass substrate in this order.

Furthermore, the present invention provides a coated glass in which an $SnO_2$ thin film and a $TiO_2$ thin film are formed on/above a glass substrate in this order, in which the $SnO_2$ thin film has a film thickness of from 200 to 500 nm, the $TiO_2$ thin film has a film thickness of from 20 to 60 nm, a C-light-source haze rate is 1% or less, and a difference between shading coefficients (SCs) before and after a formation of the $TiO_2$ thin film (SC before formation of $TiO_2$ thin film - SC after formation of $TiO_2$ thin film) is 0.04 or more.

The coated glass of the present invention may contain an $SiO_x$ ($0<x\leq2$) thin film having a film thickness of 40 to 90 nm formed between the glass substrate and the $SnO_2$ thin film.

The coated glass of the present invention preferably has a value of root mean square of slopes made by irregularities present on the surface of the $SnO_2$ thin film of 0.58 or more.

In the coated glass of the present invention, in the surface of the $SnO_2$ thin film, the area of a surface including irregularities is preferably larger than the area of a flat surface assuming no irregularities by 17% or more.

In the coated glass of the present invention, a change in an existence ratio of each of Ti element and Sn element in a film thickness direction in an interface region between the $SnO_2$ thin film and the $TiO_2$ thin film, determined by ESCA (X-ray photoelectron spectroscopy) preferably shows a distribution curve which does not have two or more inflection points.

Advantageous Effect of the Invention

According to the present invention, at the time of forming a $TiO_2$ thin film on an $SnO_2$ thin film formed on/above a substrate, deposition rate of the $TiO_2$ thin film is improved.

Furthermore, according to the present invention, for the $TiO_2$ thin film to be formed on the $SnO_2$ thin film, there can be obtained advantages that, for example, (1) the $TiO_2$ thin film is densified, (2) haze unevenness of the $TiO_2$ thin film is eliminated and the appearance is made uniform and (3) the shading coefficient (SC) (%) of the $TiO_2$ thin film is decreased. The advantage of (3) contributes to an improvement in heat insulation effect of Low-E glass.

Moreover, when the slopes of irregularities present on the $SnO_2$ thin film surface that becomes a ground of the $TiO_2$ thin film fall within a specific range, an increase in the haze rate caused by $TiO_2$ thin film formation can be suppressed.

In addition, when an increment of the area of a surface including irregularities to the area of a flat plane assuming no irregularities, in the $SnO_2$ thin film surface that becomes a ground of the $TiO_2$ thin film, falls within a specific range, an increase in the haze rate due to $TiO_2$ thin film formation can be suppressed.

Brief Description of the Drawings

[FIG. 1] FIG. 1 is a scanning electron microscope (SEM) photograph of an $SnO_2$ thin film surface on which a $TiO_2$ is formed by using TTIP as a raw material.

[FIG. 2] FIG. 2(a) is a cross-sectional SEM photograph of a fluorine-doped $SnO_2$ (FTO) thin film where a $TiO_2$ thin film is formed on the surface thereof and FIG. 2(b) is an enlarged view of the site where a $TiO_2$ thin film is formed.

[FIG. 3] FIG. 3 is a graph showing, in the case where a $TiO_2$ thin film is formed on an antimony (Sb)-doped $SnO_2$ thin film formed on a glass substrate, a relationship between the concentration ratio of MBTC to TTIP (MBTC (mol%)/TTIP (mol%)) and the film thickness (nm) of the formed $TiO_2$ thin film and also C-light-source haze rate (%).

[FIG. 4] FIGs. 4(a) and 4(b) are photographs where, in the case where a $TiO_2$ thin film is formed on an antimony (Sb)-doped $SnO_2$ thin film formed on a glass substrate, the glass substrate is photographed from the side of the $TiO_2$ thin film. FIG. 4(a) is the case where MBTC is not added and FIG. 4(b) is the case where MBTC is added in an amount of 0.05 as a concentration ratio to TTIP (MBTC (mol%)/TTIP (mol%)).

[FIG. 5] FIG. 5 is a graph showing, in the case where a $TiO_2$ thin film is formed on an antimony (Sb)-doped $SnO_2$ thin film formed on a glass substrate, a relationship between the film thickness (nm) of the $TiO_2$ thin film and C-light-source haze rate (%).

[FIG. 6] FIG. 6 is a graph showing, in the case where a $TiO_2$ thin film is formed on an antimony (Sb)-doped $SnO_2$ thin film formed on a glass substrate, a relationship between the film thickness (nm) of the $TiO_2$ thin film and shading coefficient (SC).

[FIG. 7] FIG. 7 is a graph showing, in the case where a $TiO_2$ thin film is formed on an antimony (Sb)-doped $SnO_2$ thin film formed on a glass substrate, a relationship between the film thickness (nm) of the $TiO_2$ thin film and visible light optical reflectance (Rv) (%).

[FIG. 8] FIG. 8 is a cross-sectional SEM photograph of an antimony (Sb)-doped $SnO_2$ thin film formed on a substrate.

[FIG. 9] FIG. 9 is a cross-sectional SEM photograph after $TiO_2$ thin film formation in the case where MBTC is not added.

[FIG. 10] FIG. 10 is a cross-sectional SEM photograph after $TiO_2$ thin film formation in the case where MBTC is added in an amount of 0.05 as a concentration ratio to TTIP (MBTC (mol%)/TTIP (mol%)).

[FIG. 11] FIG. 11 is a graph showing a relationship between the depth from a $TiO_2$ thin film surface (sputtering time) and element compositional ratios calculated based on each X-ray count of Ti2p, Sn3d5 and O1s.

[FIG. 12] FIG. 12 is a graph in which, in the case where a $TiO_2$ thin film is formed on an antimony (Sb)-doped $SnO_2$ thin film formed on a glass substrate, influences on C-light-source haze rate (%) by the presence and the absence of the $TiO_2$ thin film are compared.

[FIG. 13] FIG. 13 is a graph showing a relationship between the root mean square ($S_{dq}$) of slopes of irregularities present on an $SnO_2$ thin film surface and C-light-source haze rate.

[FIG. 14] FIG. 14 is a graph showing a relationship between an increment (surface area ratio, $S_{dr}$) of the area of a surface including irregularities to the area of a flat plane assuming no irregularities, in the surface of the $SnO_2$ thin film, and C-light-source haze rate.

[FIG. 15] FIG. 15 is a graph showing variation ranges of a max PV value and surface roughness (RMS) on an $SnO_2$ thin film surface.

Modes for Carrying Out the Invention

The following will describe the method for forming a $TiO_2$ thin film and the coated glass of the present invention with reference to specific embodiments.

In general, in the case where a $TiO_2$ thin film is formed by an atmospheric pressure CVD method, a Ti raw material is supplied on a substrate heated to a predetermined temperature and the Ti raw material is made to react with oxygen ($O_2$) to form the $TiO_2$ thin film. As the Ti raw material, titanium tetraisopropoxide (TTIP) and titanium chloride ($TiCl_4$) are generally used. Since TTIP does not contain highly reactive chlorine, reaction control thereof is easy and handling is simple and convenient even in the atmosphere containing moisture, for example. Titanium chloride ($TiCl_4$) is highly reactive and is advantageous when it is desired to enhance a deposition rate. However, $TiCl_4$ has such a problem that, in the case where it is supplied on a glass substrate, Na contained in the glass substrate and Cl contained in $TiCl_4$ react with each other to form NaCl and thus haze occurs. Therefore, in the method for forming a $TiO_2$ thin film of the present invention, TTIP is used as the Ti raw material.

In the method for forming a $TiO_2$ thin film of the present invention, the $TiO_2$ thin film is formed by using an atmospheric pressure CVD method, on an $SnO_2$ thin film formed on/above a substrate. The substrate above which the $TiO_2$ thin film is formed is not particularly limited and may be a ceramic-made substrate or a plastic-made substrate. However, a glass-made substrate is preferred since it has excellent transparency, high strength and good heat resistance.

As types of glass, there may be mentioned soda lime silicate glass, aluminosilicate glass, borate glass, lithium aluminosilicate glass, quartz glass, borosilicate glass, alkali-free glass, and the like. The glass is preferably colorless and transparent.

In the case of a glass substrate, the thickness is preferably from 0.2 to 6.0 mm. When the thickness of the glass substrate falls within this range, strength is high. When the degree of transparency of a substrate is expressed by transmittance, the substrate preferably has a transmittance of 80% or more. It is desirable that the glass substrate is sufficient in electrical insulating properties and has high chemical and physical durability.

Since an $SnO_2$ thin film shows high reflectance in a wavelength region of from near infrared to far infrared, in the case where the coated glass obtained by the method for forming a $TiO_2$ thin film of the present invention is used as Low-E glass, shading ability of the Low-E glass is improved.

The $SnO_2$ thin film may be a film formed of $SnO_2$ alone but may be a film containing fluorine (F) or antimony (Sb) as a dopant. In the case where a film containing the dopant is used as the $SnO_2$ thin film, since light absorbability in a wavelength range of from visible light to near infrared is imparted, at the time when the coated glass obtained by the method for forming a $TiO_2$ thin film of the present invention is used as Low-E glass, the shading ability of the Low-E glass is further improved.

In the case where F is contained as a dopant, it is preferably from 0.01 to 0.1 as a molar ratio to Sn (F/Sn) in the $SnO_2$ thin film. On the other hand, in the case where Sb is contained as a dopant, it is preferably from 0.01 to 0.5 as a molar ratio to Sn (Sb/Sn) in the $SnO_2$ thin film.

In the case where the coated glass obtained by the method for forming a $TiO_2$ thin film of the present invention is used as Low-E glass, the film thickness of the $SnO_2$ thin film is from 200 to 500 nm. When the film thickness of the $SnO_2$ thin film is less than 200 nm, a sheet resistance value is increased, so that emissivity is increased and Low-E performance is decreased. On the other hand, when the film thickness of the $SnO_2$ thin film exceeds 500 nm, reflection color from the coated surface is prone to vary resulting from film thickness distribution of the $SnO_2$ thin film, so that uniformity of the appearance is impaired.

The film thickness of the $SnO_2$ thin film is preferably from 240 to 350 nm, more preferably from 260 to 330 nm and particularly preferably from 310 to 330 nm.

As shown in FIGs. 1 and 2, fine irregularities are present on an $SnO_2$ thin film surface composed of crystal grains. The present inventors have found that a difference in the fine irregularity patterns has an influence on haze rate of a coated glass where a $TiO_2$ thin film is formed on an $SnO_2$ thin film. In the present invention, as methods of quantifying the fine irregularity pattern, there have been used a method of statistically comparing slopes of micro regions and a method of statistically comparing an increase in surface area of an irregular plane to a flat plane. This point will be mentioned later.

In the method for forming a $TiO_2$ thin film of the present invention, an $SiO_x$ ($0<x\leq2$) thin film may be formed between the substrate and the $SnO_2$ thin film.

In the case where an alkali-containing glass substrate such as soda lime silicate glass is used as a substrate, diffusion of an alkali component from the glass substrate to the $SnO_2$ thin film becomes a problem. In the case where the $SiO_x$ ($0<x\leq2$) thin film is formed between the substrate and the $SnO_2$ thin film, the $SiO_x$ ($0<x\leq2$) thin film functions as an alkali barrier film that suppresses the diffusion of the alkali component to the $SnO_2$ thin film.

Moreover, $SiO_x$ ($0<x\leq2$) has an intermediate refractive index between that of the glass constituting the substrate and $SnO_2$ constituting the $SnO_2$ thin film and hence also exhibits a function of reducing the difference in the refractive index between the glass substrate and the $SnO_2$ thin film.

The film thickness of the $SiO_x$ ($0<x\leq2$) thin film to be formed between the substrate and the $SnO_2$ thin film is preferably from 40 to 90 nm.

In the method for forming a $TiO_2$ thin film of the present invention, when a raw material gas contains titanium tetraisopropoxide (TTIP) and a tin chloride and the amount of the tin chloride is from 0.02 to 0.1 as a concentration ratio to the titanium tetraisopropoxide (TTIP) (tin chloride (mol%)/TTIP (mol%)) at the time of forming the $TiO_2$ thin film by using an atmospheric pressure CVD method, on the $SnO_2$ thin film formed on/above a substrate, the deposition rate of the $TiO_2$ thin film is improved.

The reason why the deposition rate of the $TiO_2$ thin film is improved by adding the tin chloride as an auxiliary raw material at the time of forming the $TiO_2$ thin film on the $SnO_2$ thin film is not clear but it is presumed that alleviation of such a condition that $TiO_2$ growth nuclei are hardly generated on the $SnO_2$ thin film may be related. That is, it is presumed that, the $SnO_2$ thin film surface is in a state of having a high energy barrier toward the $TiO_2$ growth nuclei but, in the method for forming a $TiO_2$ thin film of the present invention, since a mixed layer of $SnO_2$ and $TiO_2$ is formed at the early stage of film growth, $TiO_2$ generation points are increased due to the decrease in the energy barrier at the interface between the $SnO_2$ thin film and the $TiO_2$ thin film. According to the mechanism, it is considered that the $TiO_2$ thin film grows still in high density from the interface between the $SnO_2$ thin film and the $TiO_2$ thin film and thus the deposition rate is increased.

However, when the concentration ratio to TTIP (tin chloride (mol%)/TTIP (mol%)) is less than 0.02, the effect of improving the deposition rate cannot be exhibited. Moreover, there is a concern that the $TiO_2$ thin film to be formed may become inhomogeneous and defects in appearance such as color unevenness and haze unevenness may occur. On the other hand, when the concentration ratio to TTIP (tin chloride (mol%)/TTIP (mol%)) exceeds 0.1, the deposition rate rather decreases and C-light-source haze rate increases, so that the requirement relating to the C-light-source haze rate cannot be satisfied in the case where the coated glass obtained by the method for forming a $TiO_2$ thin film of the present invention is used as Low-E glass.

The amount of the tin chloride, as the concentration ratio to TTIP (tin chloride (mol%)/TTIP (mol%)), is preferably from 0.02 to 0.1, more preferably from 0.025 to 0.08, and particularly preferably from 0.025 to 0.07.

In the method for forming a $TiO_2$ thin film of the present invention, as the tin chloride to be added as an auxiliary raw material, use can be made of , for example, $SnCl_4$, MBTC (monobutyltin trichloride), DBTC (dibutyltin dichloride), or TBTC (tributyltin chloride), or the like. Of these, MBTC and $SnCl_4$ are preferred for the reasons that the control of the reactivity in the vaporization process is easy and the like, and MBTC is particularly preferred.

In the method for forming a $TiO_2$ thin film of the present invention, the substrate temperature in $TiO_2$ thin film formation is preferably from 400 to 650°C from the viewpoint of an improvement in the deposition rate, more preferably from 450°C to 600°C, further preferably from 520°C to 600°C, and particularly preferably from 530°C to 580°C from the viewpoint of compatibility to the online forming process of sheet glass.

Moreover, in the method for forming a $TiO_2$ thin film of the present invention, TTIP as a Ti raw material and the tin chloride as an auxiliary raw material may be supplied by a raw material gas supply means of a pre-mix mode where raw materials are supplied onto a substrate in a previously mixed state or may be supplied by a raw material gas supply means of a post-mix mode where raw materials are supplied separately and then mixed on a substrate.

The $TiO_2$ thin film to be formed by the method for forming a $TiO_2$ thin film of the present invention has advantages to be described below.

Densification of $TiO_2$ Thin Film

As mentioned above, when a $TiO_2$ thin film is formed on an $SnO_2$ thin film surface by using TTIP as a raw material, the $TiO_2$ thin film to be formed is prone to have a low density structure. To the contrary, according to the method for forming a $TiO_2$ thin film of the present invention, the $TiO_2$ thin film to be formed is densified and the density of the $TiO_2$ thin film is enhanced. The reason why the $TiO_2$ thin film to be formed is densified is not clear but it is presumed that this is because $TiO_2$ generation points are increased by adding a tin chloride as an auxiliary raw material. In the present invention, as a method for specifying the change in the film formation mechanism, there have been used a profile of element compositional ratios (existence ratios of Ti element and Sn element) in the interface region between the $SnO_2$ thin film and the $TiO_2$ thin film in a film thickness direction by ESCA (X-ray photoelectron spectroscopy). This point will be mentioned later.

Uniformization of Appearance of $TiO_2$ Thin Film

When a $TiO_2$ thin film is formed on an $SnO_2$ thin film surface by using TTIP as a raw material, defects in appearance such as color unevenness and haze unevenness may occur in the formed $TiO_2$ thin film in some cases. According to the method for forming a $TiO_2$ thin film of the present invention, there can be formed a $TiO_2$ thin film having uniform appearance in which these defects in appearance are not present.

The above-mentioned defects in appearance are considered to occur due to occurrence of unevenness in the formation of the $TiO_2$ thin film caused by minute attached substances (e.g., marks of washing) present on the $SnO_2$ thin film surface and an air stream pattern at the time when the raw material gas comes into contact with the $SnO_2$ thin film

surface. That is, it is considered that the sites on which the minute attached substances are attached and a difference in the raw material concentration (TTIP concentration) reaching the $SnO_2$ thin film surface result in a difference in density of the $TiO_2$ generation points and a variation in the deposition rate of the $TiO_2$ thin film, and thus unevenness occurs in the formation of the $TiO_2$ thin film. To the contrary, in the method for forming a $TiO_2$ thin film of the present invention, since the $TiO_2$ generation points are increased by adding the tin chloride as an auxiliary raw material, it is considered that the influences of the sites on which the minute attached substances are attached and a difference in the raw material concentration (TTIP concentration) reaching the $SnO_2$ thin film surface are reduced. Thereby, it is considered that the formation of the $TiO_2$ thin film is made uniform and thus a $TiO_2$ thin film having uniform appearance can be formed.

Decrease in Shading Coefficient (SC)

Moreover, the coated glass obtained by the method for forming a $TiO_2$ thin film of the present invention has a decreased shading coefficient (SC) as compared with the case of a coated glass where the $TiO_2$ thin film is formed without adding any tin chloride as an auxiliary raw material. It is considered that the reason why SC is decreased is that the refractive index of the $TiO_2$ thin film is increased by densification of the $TiO_2$ thin film to be formed and thus the visible light optical reflectance (Rv) of the coated glass has been increased.

In the coated glass obtained by the method for forming a $TiO_2$ thin film of the present invention, a difference in SC before and after $TiO_2$ thin film formation (SC before $TiO_2$ thin film formation - SC after $TiO_2$ thin film formation) is preferably 0.04 or more since the heat insulation effect is improved in the case where the coated glass is used as Low-E glass, and is more preferably 0.05 or more.

Suppression of Haze

Moreover, the coated glass obtained by the method for forming a $TiO_2$ thin film of the present invention has low C-light-source haze rate as compared with the case of a coated glass where the $TiO_2$ thin film is formed without adding any tin chloride as an auxiliary raw material. In the case of adding no tin chloride, the $TiO_2$ thin film has a structure in which fine $TiO_2$ crystal grains are attached on the $SnO_2$ thin film surface but, in the case of adding a tin chloride, the $TiO_2$ thin film has a dense structure. Since fine $TiO_2$ crystal grains become a cause of light scattering, it is considered that a $TiO_2$ thin film having no such a structure is formed and hence the C-light-source haze rate is decreased.

However, in a coated glass where an $SnO_2$ thin film and a $TiO_2$ thin film are formed on/above a glass substrate in this order, as factors having an influence on the C-light-source haze rate of the coated glass, there exist, in addition to the film structure of the $TiO_2$ thin film, (a) the film thickness of the $TiO_2$ thin film and (b) the C-light-source haze rate of the ground of the $TiO_2$ thin film, i.e., the glass substrate on/above which the $SnO_2$ thin film is formed. As compared with the influence of (a) and (b) on the C-light-source haze rate, the influence of the film structure of the $TiO_2$ thin film is small. Therefore, in order to decrease the C-light-source haze rate of the coated glass, it is also necessary to investigate the influence of (a) and (b).

The above (a), i.e., the film thickness of the $TiO_2$ thin film is preferably from 20 to 60 nm. When the film thickness of the $TiO_2$ thin film is less than 20 nm, the increase in reflectance is generated only in a short wavelength region of visible light, so that the effect of the decrease in SC remarkably decreases.

On the other hand, when the film thickness of the $TiO_2$ thin film exceeds 60 nm, the C-light-source haze rate of the coated glass remarkably increases and the requirement on the C-light-source haze rate of the coated glass to be mentioned later cannot be satisfied. Moreover, since a peak of the reflectance extends to a region of a wavelength of 600 nm or more, reflection color tone becomes from orange to bronze-like one. Such a color tone is not preferred as Low-E glass for construction.

When the film thickness of the $TiO_2$ thin film is from 40 to 50 nm, a reflection peak is generated in a wavelength region of 500 to 600 nm and the reflection color tone of the coated glass becomes neutral, that is, the reflection color tone becomes colorless, so that this is more preferred.

With regard to the above (b), i.e., the ground of the $TiO_2$ thin film, a difference of the fine irregularity patterns present on the $SnO_2$ thin film surface has an influence on the haze rate of the coated glass where the $TiO_2$ thin film is formed on the $SnO_2$ thin film. In the present invention, as methods of quantifying the fine irregularity pattern, there have been used a method of statistically comparing slopes made by the irregularities of micro regions and a method of statistically comparing an increase in surface area of an irregular plane to a flat plane.

The quantification of the fine irregularity pattern present on the $SnO_2$ thin film surface can be performed by the following procedures.

When the $SnO_2$ thin film surface is photographed on an atomic force microscope (AFM), an AFM image is obtained as one in which height Z of each point obtained by dividing a sample surface (X-Y plane) by a two-dimensional mesh is image-processed. When analysis by a nano-scale 3D image processing software "SPIP™ (Scanning Probe Image Processor) manufactured by Image Metrology Company" developed for a scanning probe microscope is performed

by using $Z(X_k,Y_l)$ (k and l are each a natural number) coordinate data constituting the AFM image, it has been found that the increase in the C-light-source haze rate after $TiO_2$ thin film formation can be reasonably explained by values $S_{dq}$, i.e., root mean square slope and $S_{dr}$, i.e., surface area ratio, which are calculated by the software.

$S_{dq}$, i.e., root mean square slope corresponds to the value of root mean square of slopes of the $SnO_2$ thin film surface, the slopes being made by the irregularities in the target region, and is defined by the following expression.

[Math. 1]

$$S_{dq} = \sqrt{\frac{1}{(M-1)(N-1)} \sum_{k=0}^{M-1} \sum_{l=0}^{N-1} \left\{ \left(\frac{z(x_k,y_l)-z(x_{k-1},y_l)}{dx}\right)^2 + \left(\frac{z(x_k,y_l)-z(x_k,y_{l-1})}{dx}\right)^2 \right\}}$$

Moreover, $S_{dr}$, i.e., surface area ratio is defined by the following expression, as an increment of the area of a surface including the irregularities to the area of a flat XY plane assuming no irregularities (an increment of the area of a surface including the irregularities considering the height Z derived from the irregularities relative to a flat XY plane).

[Math. 2]

$$S_{dr} = \frac{\left(\sum_{k=0}^{M-2} \sum_{l=0}^{N-2} A_{kl}\right)-(M-1)(N-1)dxdy}{(M-1)(N-1)dxdy} \times 100(\%)$$

$A_{kl}$ in the above expression is defined by the following expression.

[Math. 3]

$$A_{kl} = \frac{1}{4}\left[\sqrt{dy^2 + \left\{z(x_k,y_l) - z\left(x_k,y_{l+1}\right)\right\}^2} + \sqrt{dy^2 + \left\{z\left(x_{k+1},y_l\right) - z\left(x_k,y_{l+1}\right)\right\}^2}\right] +$$
$$\frac{1}{4}\left[\sqrt{dy^2 + \left\{z(x_k,y_l) - z\left(x_{k+1},y_l\right)\right\}^2} + \sqrt{dy^2 + \left\{z\left(x_k,y_{l+1}\right) - z\left(x_{k+1},y_{l+1}\right)\right\}^2}\right]$$

In the case of a completely flat surface where irregularities are not present on the surface, since the area of the surface considering the height Z and the area of the XY plane are equal, $S_{dr} = 0\%$.

In the method for forming a $TiO_2$ thin film of the present invention, the value of $S_{dq}$ is preferably 0.58 or more because the C-light-source haze rate of the coated glass where the $SnO_2$ thin film and the $TiO_2$ thin film are formed on/above the glass substrate in this order is decreased, and is more preferably 0.62 or more.

Moreover, the value of $S_{dr}$ is preferably 17% or more because the C-light-source haze rate of the coated glass where the $SnO_2$ thin film and the $TiO_2$ thin film are formed on/above the glass substrate in this order is decreased, and is more preferably 18% or more.

In the coated glass obtained by the method for forming a $TiO_2$ thin film of the present invention, the C-light-source haze rate is preferably 1% or less, more preferably 0.8% or less and particularly preferably 0.7% or less.

The coated glass obtained by the method for forming a $TiO_2$ thin film of the present invention preferably contains no low density $TiO_2$ layer at the interface between the $SnO_2$ thin film and the $TiO_2$ thin film. The fact that no low density $TiO_2$ layer is contained at the interface between the $SnO_2$ thin film and the $TiO_2$ thin film can be confirmed by measuring the existence ratios of Ti element and Sn element in an interface region between the $SnO_2$ thin film and the $TiO_2$ thin film along a film thickness direction. In the case where any low density $TiO_2$ layer is not contained at the interface between the $SnO_2$ thin film and the $TiO_2$ thin film, a curve indicating the existence ratio of each of the Ti element and the Sn element becomes a curve which is not discontinuous and does not have two or more inflection points. The curve which does not have two or more inflection points is a curve having no inflection point or a curve having one inflection point.

Examples

The present invention will be described in detail below with reference to Examples. However, the present invention should not be construed as being limited thereto.

(Example 1 and Comparative Example 1)

In the present Example and Comparative Example, a $TiO_2$ thin film was formed on an antimony (Sb)-doped $SnO_2$ thin film by using an atmospheric pressure CVD method. The antimony (Sb)-doped $SnO_2$ thin film has a molar ratio of Sb/Sn of 0.05. The antimony (Sb)-doped $SnO_2$ thin film is formed on an $SiO_x$ ($0<x\leq2$) thin film formed on a glass substrate (soda lime silicate glass substrate) and has a film thickness of 320 nm.

The $SiO_x$ ($0<x\leq2$) thin film has a film thickness of 70 nm.

As an auxiliary raw material, MBTC was added in an amount of 0 to 0.3 as a concentration ratio to TTIP (MBTC (mol%)/TTIP (mol%)). The concentration ratio of MBTC to TTIP in the range of 0.02 to 0.1 is Example 1 and in a range other than the range is Comparative Example 1.

The substrate temperature at the time of $TiO_2$ thin film formation was 550°C.

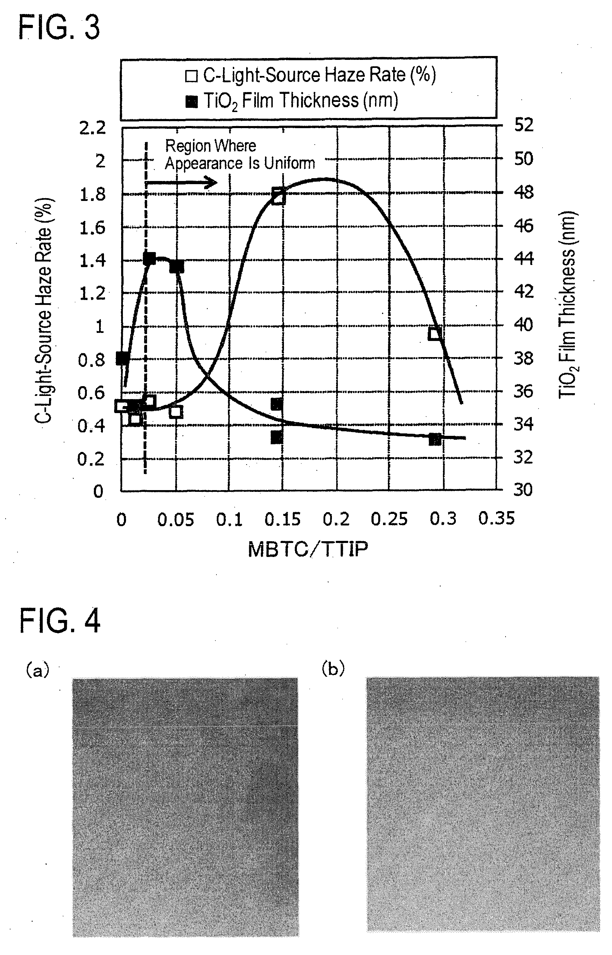

FIG. 3 shows a relationship between the concentration ratio of MBTC to TTIP (MBTC (mol%)/TTIP (mol%)) and the film thickness (nm) of the formed $TiO_2$ thin film and also C-light-source haze rate (%).

Measurement procedures of the film thickness of the $TiO_2$ thin film and the C-light-source haze rate are as follows.

Film thickness of $TiO_2$ thin film: Ti count number on an X-ray fluorescence spectroscopic analyzer (XRF) is converted into film thickness.

C-light-source haze rate: measurement is performed by using a haze meter.

For comparison, the C-light-source haze rate was also measured before $TiO_2$ thin film formation.

As is apparent from FIG. 3, as the concentration ratio of MBTC to TTIP is increased, the film thickness of the $TiO_2$ thin film is increased and becomes a maximum value when the concentration ratio of MBTC to TTIP is between 0.02 and 0.1 (Example 1). Furthermore, although the C-light-source haze rate before $TiO_2$ thin film formation is about 0.4%, it is a value lower than 1% until the concentration ratio of MBTC to TTIP reaches 0.1 (Example 1), is sharply increased to 1.8% when the concentration ratio of MBTC to TTIP is 0.14, and is decreased to about 1% when the concentration ratio of MBTC to TTIP is around 0.28 (Comparative Example 1). From the results, it is understood that when the concentration ratio of MBTC to TTIP is between 0.02 and 0.1, the deposition efficiency of the $TiO_2$ thin film becomes maximum and the C-light-source haze rate becomes 1% or less (Example 1).

When the concentration ratio of MBTC to TTIP is less than 0.02, defects in appearance such as color unevenness and haze unevenness (a state that appearance is not uniform) were observed (Comparative Example 1).

FIGs. 4(a) and 4(b) are photographs where, in the case where a $TiO_2$ thin film is formed on an antimony (Sb)-doped $SnO_2$ thin film formed on a glass substrate, the glass substrate was photographed from the side of the $TiO_2$ thin film. FIG. 4(a) is the case where MBTC was not added (concentration ratio of MBTC to TTIP is 0) (Comparative Example 1) and FIG. 4(b) is the case where MBTC was added in an amount of 0.05 as a concentration ratio to TTIP (MBTC (mol%)/TTIP (mol%)) (Example 1). In FIG. 4(a) (Comparative Example 1), a distribution (unevenness) in the reflection color of the $TiO_2$ thin film is generated but, in FIG. 4(b) (Example 1), the reflection color of the $TiO_2$ thin film is made uniform.

(Example 2 and Comparative Example 2)

In the present Example and Comparative Example, a $TiO_2$ thin film was formed on an antimony (Sb)-doped $SnO_2$ thin film by the similar procedures as in Example 1. MBTC was added in an amount of 0.05 as a concentration ratio to TTIP (MBTC (mol%)/TTIP (mol%)). By controlling film formation time, a plurality of samples different in the film thickness of the $TiO_2$ thin film was prepared (Example 2).

Moreover, also in the case where MBTC was not added (TTIP 100%), a plurality of samples different in the film thickness of the $TiO_2$ thin film was prepared (Comparative Example 2).

Furthermore, in the case where MBTC was not added (TTIP 100%), a sample where a $TiO_2$ thin film was formed on an antimony (Sb)-doped $SnO_2$ thin film having C-light-source haze rate of about 0.8% was also prepared (Comparative Example 2).

For these samples, the C-light-source haze rate was measured by the same procedures as in Example 1.

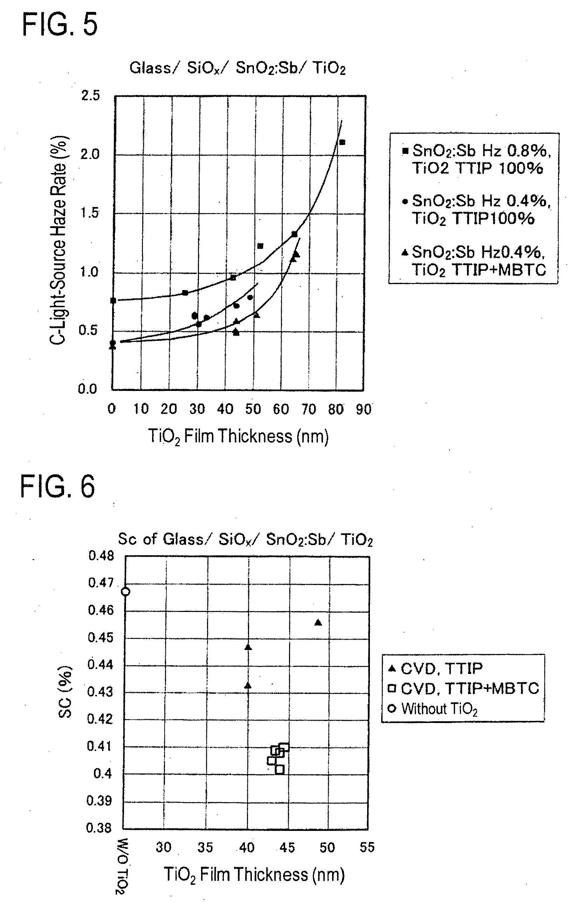

FIG. 5 shows a relationship between the film thickness (nm) of the $TiO_2$ thin film and the C-light-source haze rate (%).

As is apparent from FIG. 5, in both of the case where MBTC was added (Example 2) and the case where MBTC was not added (Comparative Example 2), as the film thickness of the $TiO_2$ thin film is increased, the C-light-source haze rate was increased and, when the film thickness of the $TiO_2$ thin film exceeds 60 nm, the C-light-source haze rate is remarkably increased. With regard to the case where MBTC was not added (Comparative Example 2), as compared with one where a $TiO_2$ thin film was formed on an antimony (Sb)-doped $SnO_2$ thin film having C-light-source haze rate of about 0.4, one where a $TiO_2$ thin film was formed on an antimony (Sb)-doped $SnO_2$ thin film having the rate of about 0.8 exhibited high C-light-source haze rate. Moreover, when comparison was conducted with regard to one where a $TiO_2$ thin film was formed on an antimony (Sb)-doped $SnO_2$ thin film having C-light-source haze rate of about 0.4, the C-light-source haze rate was low in the case where MBTC was added in an amount of 0.05 as a concentration ratio to TTIP (MBTC (mol%)/TTIP (mol%)) (Example 2), as compared with the case where MBTC was not added (Comparative Example 2).

(Example 3 and Comparative Example 3)

In the present Example and Comparative Example, a $TiO_2$ thin film was formed on an antimony (Sb)-doped $SnO_2$ thin film by the same procedures as in Example 1. MBTC was added in an amount of 0.05 as a concentration ratio to TTIP (MBTC (mol%)/TTIP (mol%)) (Example 3).

Moreover, also in the case where MBTC was not added, a $TiO_2$ thin film was formed on an antimony (Sb)-doped $SnO_2$ thin film by the same procedures as in Example 1 (Comparative Example 3).

For these Examples, shading coefficient (SC) was measured by the following procedures.

By using a spectrophotometer, spectral transmittance, reflectance on glass surface and reflectance on coated surface in the wavelength range of 300 nm to 2500 nm were each measured. Moreover, emissivity on the coated surface was measured by using an emissivity meter. Based on these measured values, SC was calculated by using the calculation formula defined in JIS R 3106:1998.

Moreover, for these Examples, visible light optical reflectance (Rv) was measured by the following procedures.

Based on the measured values of the spectral reflectance measured on the spectrophotometer, Rv was calculated by using the calculation formula defined in JIS R 3106:1998.

The visible light optical reflectance (Rv) was measured for both of the side on which the $TiO_2$ thin film was formed (coated side) and the glass substrate side (glass side).

Moreover, for comparison, SC and the visible light optical reflectance (Rv) were also measured before $TiO_2$ thin film formation.

FIG. 6 shows a relationship between the film thickness (nm) of the $TiO_2$ thin film and SC. As is apparent from FIG. 6, in both of the case where MBTC was added (Example 3) and the case where MBTC was not added (Comparative Example 3), SC was decreased as compared with that before $TiO_2$ thin film formation. Furthermore, in the case where MBTC was added in an amount of 0.05 as a concentration ratio to TTIP (MBTC (mol%)/TTIP (mol%)) (Example 3), SC was decreased as compared with the case where MBTC was not added (Comparative Example 3).

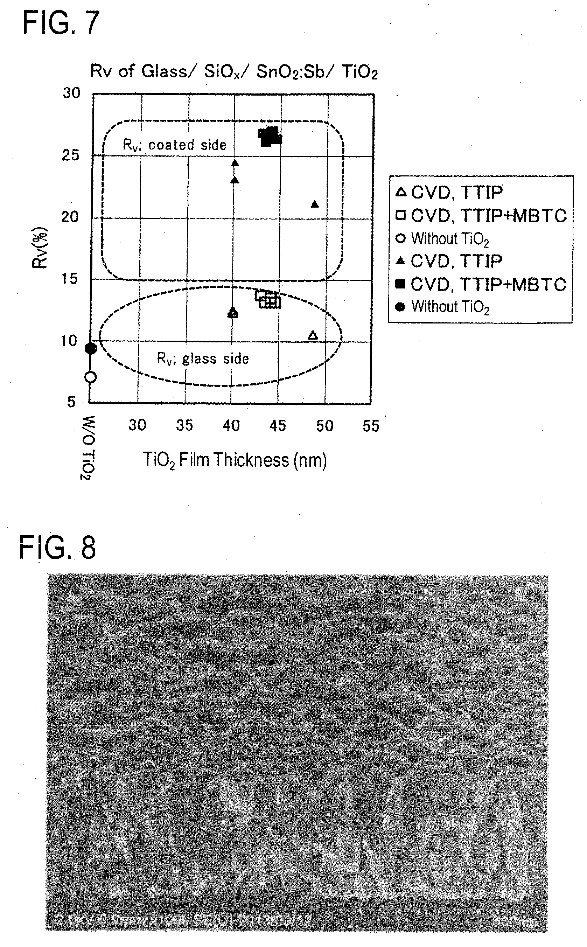

FIG. 7 shows a relationship between the film thickness (nm) of the $TiO_2$ thin film and the visible light optical reflectance (Rv) (%). As is apparent from FIG. 7, in either case, the visible light optical reflectance (Rv) is higher at the side on which the $TiO_2$ thin film is formed (coated side, the side on which the Sb-doped $SnO_2$ thin film is formed in the case of the sample before $TiO_2$ thin film formation) than at the glass substrate side (glass side). In both of the case where MBTC is added (Example 3) and the case where MBTC is not added (Comparative Example 3), the visible light optical reflectance (Rv) is high as compared with that before $TiO_2$ thin film formation. Furthermore, the visible light optical reflectance (Rv) is higher in the case where MBTC is added in an amount of 0.05 as a concentration ratio to TTIP (MBTC (mol%)/TTIP (mol%)) (Example 3) than in the case where MBTC is not added (Comparative Example 3).

From these results, it can be confirmed that SC is decreased when the visible light optical reflectance (Rv) is enhanced by the formation of the $TiO_2$ thin film. Furthermore, in the case where MBTC is added in an amount of 0.05 as a concentration ratio to TTIP (MBTC (mol%)/TTIP (mol%)) (Example 3), it can be confirmed that the shading coefficient (SC) is decreased due to an enhancement of the visible light optical reflectance (Rv), as compared with the case where MBTC is not added (Comparative Example 3). Moreover, in the case where MBTC was added in an amount of 0.05 as a concentration ratio to TTIP (MBTC (mol%)/TTIP (mol%)) (Example 2), the C-light-source haze rate was also low. Thus, Low-E glass having an enhanced heat insulation effect can be obtained.

It is considered that the reason why the visible light optical reflectance (Rv) is improved in the case where MBTC is added in an amount of 0.05 as a concentration ratio to TTIP (MBTC (mol%)/TTIP (mol%)) (Example 3) as compared with the case where MBTC is not added (Comparative Example 3) is that the refractive index of the $TiO_2$ thin film is increased by the densification of the $TiO_2$ thin film to be formed and hence the visible light optical reflectance (Rv) of the coated glass is increased.

(Example 4 and Comparative Example 4)

In the present Example and Comparative Example, a $TiO_2$ thin film was formed on an antimony (Sb)-doped $SnO_2$ thin film by the same procedures as in Example 1. MBTC was added in an amount of 0.05 as a concentration ratio to TTIP (MBTC (mol%)/TTIP (mol%)) (Example 4).

Moreover, also in the case where MBTC was not added, a $TiO_2$ thin film was formed on an antimony (Sb)-doped $SnO_2$ thin film by the same procedures as in Example 1 (Comparative Example 4).

For these, a fracture surface was subjected to a scanning electron microscope (SEM) observation. For comparison, also before $TiO_2$ thin film formation, a fracture surface was subjected to a scanning electron microscope (SEM) observation.

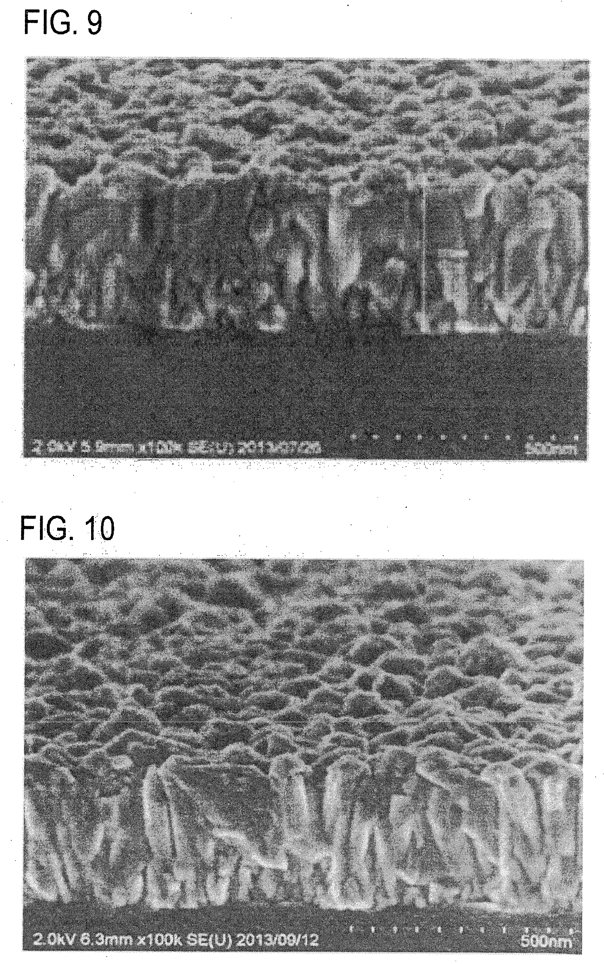

FIG. 8 is a cross-sectional SEM photograph of an antimony (Sb)-doped $SnO_2$ thin film formed before $TiO_2$ thin film formation, i.e., formed on a substrate. FIG. 9 is a cross-sectional SEM photograph after $TiO_2$ thin film formation in the case where MBTC is not added (Comparative Example 4). FIG. 10 is a cross-sectional SEM photograph after $TiO_2$ thin film formation in the case where MBTC is added in an amount of 0.05 as a concentration ratio to TTIP (MBTC (mol%)/TTIP (mol%)) (Example 4). As is apparent from FIG. 8 to FIG. 10, fine constitutional structures can be observed in the formed $TiO_2$ thin film in the case where MBTC was not added (Comparative Example 4) but, fine constitutional structure is not observed in the formed $TiO_2$ thin film and it could be confirmed that the formed $TiO_2$ thin film has a dense structure in the case where MBTC was added in an amount of 0.05 as a concentration ratio to TTIP (MBTC (mol%)/TTIP (mol%)) (Example 4).

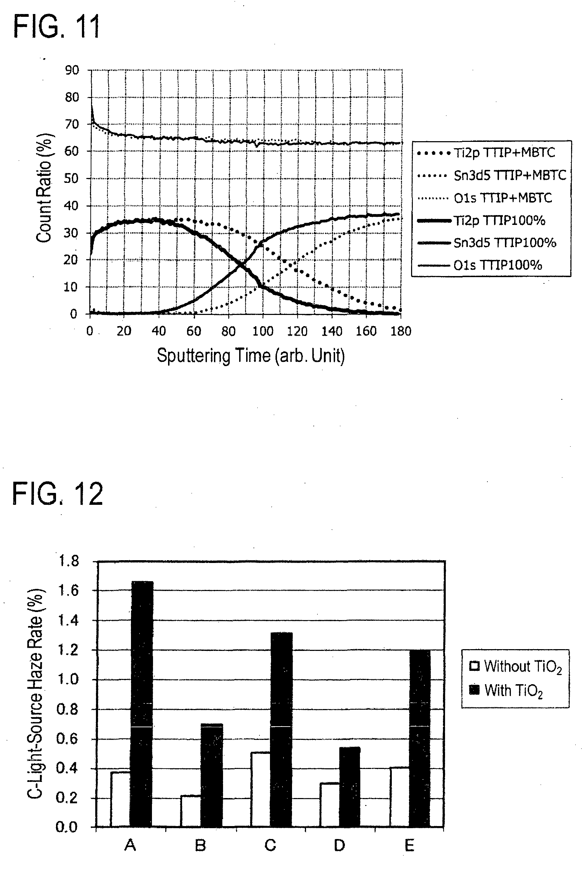

Then, for these two kinds (Example 4 and Comparative Example 4) of samples, a change in the element compositional ratios (existence ratios of Ti element and Sn element) in a thickness direction from the $TiO_2$ thin film surface was evaluated by ESCA (X-ray photoelectron spectroscopy). FIG. 11 shows a relationship between the depth from the $TiO_2$ thin film surface (sputtering time) and element compositional ratios calculated based on each X-ray count of Ti2p, Sn3d5 and O1s. However, the absolute value of the element compositional ratio is not necessarily accurate and comparison thereof as relative values is effective.

The case where MBTC was added in an amount of 0.05 as a concentration ratio to TTIP (MBTC (mol%)/TTIP (mol%)) (Example 4) is shown by a broken line and the case where MBTC was not added (Comparative Example 4) is shown by a solid line. When attention was paid to variation of Ti2p and Sn3d5 counts at the interface region (region where sputtering time is from 40 to 180) between the $SnO_2$ thin film and the $TiO_2$ thin film, smooth curves each having one inflection point were obtained in Example 4. Such curves show that the interface between the $SnO_2$ thin film and the $TiO_2$ thin film becomes unclear by the influence of the irregularities present on the $SnO_2$ thin film surface.

On the other hand, there occurs a point at which curvature becomes discontinuous in the region where the sputtering time is around 100 in Comparative Example 4. Moreover, this point being a border, the Ti2p count is sharply decreased in a depth direction at the shallower side and is gradually decreased at the deeper side. For Sn3d5, contrarily, it changes from a rapid increase to a slow increase. This fact shows that a low density $TiO_2$ layer is present at the interface region between the $SnO_2$ thin film and the $TiO_2$ thin film, in addition to the influence of the irregularities present on the $SnO_2$ thin film surface.

From these facts, it was confirmed that a $TiO_2$ thin film having a dense structure was grown from an early stage of film formation owing to the addition of MBTC.

(Experimental Example 1)

In the present Experimental Example, a $TiO_2$ thin film was formed on an $SnO_2$ thin film by the similar procedures as in Example 1. However, the $SnO_2$ thin film is a fluorine (F)-doped $SnO_2$ thin film and the film thickness is from 210 to 390 nm. The F-doped $SnO_2$ thin film has an F/Sn molar ratio of 0.3.

For these samples, the C-light-source haze rate was measured by the same procedures as in Example 1. For each sample, the C-light-source haze rates before and after $TiO_2$ thin film formation are shown in FIG. 12. As is apparent from FIG. 12, in either sample, in the case of forming the $TiO_2$ thin film, the C-light-source haze rate was increased. However, the rate of increase in the C-light-source haze rate (C-light-source haze rate after $TiO_2$ thin film formation/C-light-source haze rate after $TiO_2$ thin film formation) varies depending on the samples.

For these samples, when the surface of the $SnO_2$ thin film before $TiO_2$ thin film formation was observed on an atomic force microscope (AFM), it was revealed that they were different in the fine irregularity patterns present on the surface of the $SnO_2$ thin film composed of crystal grains. It is considered that this difference in the fine irregularity patterns has an influence on the C-light-source haze rate after $TiO_2$ thin film formation. The present inventors have used, as methods of quantifying the fine irregularity pattern, a method of statistically comparing slopes made by the irregularities of micro regions and a method of statistically comparing an increase in surface area of an irregular plane to a flat plane. Specifically, the following procedures are carried out.

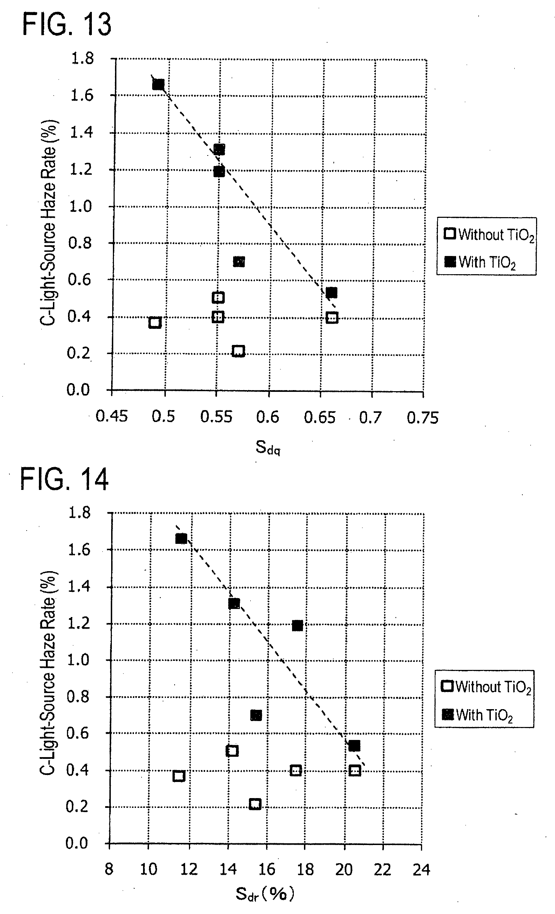

An AFM image is obtained as one in which height of each point obtained by dividing the $SnO_2$ thin film surface (X-Y plane) by a two-dimensional mesh is image-processed. Analysis by a nano-scale 3D image processing software "SPIP™ (Scanning Probe Image Processor) manufactured by Image Metrology Company" developed for a scanning probe microscope is performed by using $Z(X_k, Y_l)$ (k and l are each a natural number) coordinate data constituting the AFM image, and a relationship between values $S_{dq}$, i.e., root mean square slope and $S_{dr}$, i.e., surface area ratio, which are calculated by the software, and the C-light-source haze rate was organized. FIGs. 13 and 14 show relationships between them.

As is apparent from FIG. 13, the sample exhibiting the smallest rate of increase in the C-light-source haze rate has the largest $S_{dq}$ and the haze rate tends to increase as the value decreases. Also, as is apparent from FIG. 14, the sample exhibiting the smallest rate of increase in the C-light-source haze rate has the largest $S_{dr}$ and the haze rate tends to increase as the value decreases.

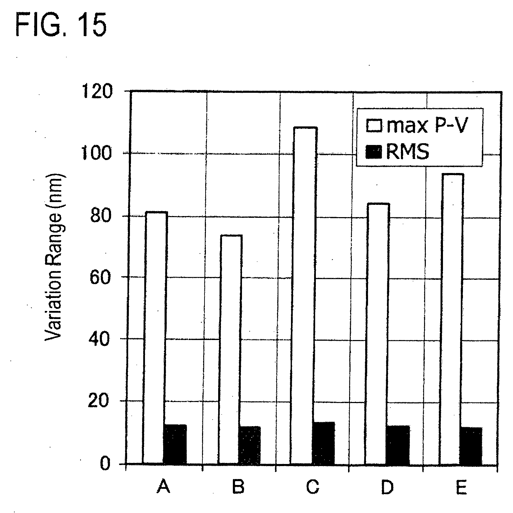

For the samples (A to E) evaluated in FIGs. 13 and 14, max PV value (maximum height difference of measured values) and surface roughness (mean square roughness, RMS) of the $SnO_2$ thin film surface were determined by the AFM measurement. FIG. 15 shows variation ranges of the max PV value and the surface roughness (RMS) on the $SnO_2$ thin film surface. As is apparent from FIG. 15, in the samples, the surface roughness (RMS) of the $SnO_2$ thin film surface is the similar level. Therefore, a high value of $S_{dq}$, i.e., root mean square slope indicates that the crystal grains constituting the $SnO_2$ thin film surface have small grain diameters. Moreover, a high value of $S_{dr}$, i.e., surface area ratio is also a result which is not contradictory to the finding that the crystal grains constituting the $SnO_2$ thin film surface have small grain diameters.

While the present invention has been described in detail and with reference to specific embodiments thereof, it will be apparent to one skilled in the art that various changes and modifications can be made therein without departing from the spirit and scope of the present invention.

The present application is based on Japanese Patent Application No. 2013-238795 filed on November 19, 2013 and Japanese Patent Application No. 2014-075636 filed on April 1, 2014, and the contents are incorporated herein by reference.

Moreover, the contents of JIS R 3106:1998 are incorporated herein by reference.

**Claims**

1. A method for forming a $TiO_2$ thin film by using an atmospheric pressure CVD method, on an $SnO_2$ thin film formed on/above a substrate, wherein a raw material gas comprises titanium tetraisopropoxide (TTIP) and a tin chloride and the amount of the tin chloride is from 0.02 to 0.1 as a concentration ratio to the titanium tetraisopropoxide (TTIP) (tin chloride (mol%)/TTIP (mol%)).

2. The method for forming a $TiO_2$ thin film according to Claim 1, wherein the amount of the tin chloride is from 0.025 to 0.08 as a concentration ratio to the titanium tetraisopropoxide (TTIP) (tin chloride (mol%)/TTIP (mol%)).

3. The method for forming a $TiO_2$ thin film according to Claim 1 or 2, wherein the tin chloride is monobutyltin trichloride (MBTC) or tin tetrachloride ($SnCl_4$).

4. The method for forming a $TiO_2$ thin film according to any one of Claims 1 to 3, wherein the substrate is a glass substrate and the substrate has a temperature of from 520 to 600°C at the time of forming the $TiO_2$ thin film.

5. The method for forming a $TiO_2$ thin film according to any one of Claims 1 to 4, wherein the $SnO_2$ thin film comprises fluorine (F) or antimony (Sb) as a dopant.

6. The method for forming a $TiO_2$ thin film according to any one of Claims 1 to 5, wherein an $SiO_x$ ($0<x\leq2$) thin film is formed between the substrate and the $SnO_2$ thin film.

7. A coated glass obtained by the method for forming a $TiO_2$ thin film described in any one of Claims 1 to 6, wherein an $SnO_2$ thin film and a $TiO_2$ thin film are formed on/above a glass substrate in this order.

8. A coated glass wherein an $SnO_2$ thin film and a $TiO_2$ thin film are formed on/above a glass substrate in this order, wherein the $SnO_2$ thin film has a film thickness of from 200 to 500 nm, the $TiO_2$ thin film has a film thickness of from 20 to 60 nm, a C-light-source haze rate is 1% or less, and a difference between shading coefficients (SCs) before and after a formation of the $TiO_2$ thin film (SC before formation of $TiO_2$ thin film - SC after formation of $TiO_2$ thin film) is 0.04 or more.

9. The coated glass according to Claim 8, comprising an $SiO_x$ ($0<x\leq2$) thin film having a film thickness of 40 to 90 nm formed between the glass substrate and the $SnO_2$ thin film.

10. The coated glass according to Claim 8 or 9, having a value of root mean square of slopes made by irregularities present on the surface of the $SnO_2$ thin film of 0.58 or more.

11. The coated glass according to any one of Claims 8 to 10, wherein in the surface of the $SnO_2$ thin film, the area of a surface including irregularities is larger than the area of a flat surface assuming no irregularities by 17% or more.

12. The coated glass according to any one of Claims 8 to 11, wherein a change in an existence ratio of each of Ti element and Sn element in a film thickness direction in an interface region between the $SnO_2$ thin film and the $TiO_2$ thin film, determined by ESCA (X-ray photoelectron spectroscopy) shows a distribution curve which does not have two or more inflection points.

FIG. 1

No-14522 2.0kV 2.0mm x100k SE(U)                    500nm

FIG. 2

(a)

TiO₂
FTO
glass

└ 100 nm

(b)

TiO₂
FTO

└─ 100 nm

# FIG. 3

# FIG. 4

(a)

(b)

## FIG. 5

Glass/ SiOx/ SnO2:Sb/ TiO2

- SnO2:Sb Hz 0.8%, TiO2 TTIP 100%
- SnO2:Sb Hz 0.4%, TiO2 TTIP100%
- SnO2:Sb Hz0.4%, TiO2 TTIP+MBTC

## FIG. 6

Sc of Glass/ SiOx/ SnO2:Sb/ TiO2

- CVD, TTIP
- CVD, TTIP+MBTC
- Without TiO2

## FIG. 7

**Rv of Glass/ SiOx/ SnO2:Sb/ TiO2**

Legend:
- △ CVD, TTIP
- □ CVD, TTIP+MBTC
- ○ Without TiO2
- ▲ CVD, TTIP
- ■ CVD, TTIP+MBTC
- ● Without TiO2

Y-axis: Rv (%)
X-axis: TiO2 Film Thickness (nm)
Rv; coated side
Rv; glass side
W/O TiO2

## FIG. 8

2.0kV 5.9mm x100k SE(U) 2013/09/12    500nm

FIG. 9

FIG. 10

2.0kV 6.3mm x100k SE(U) 2013/09/12          500nm

FIG. 11

FIG. 12

FIG. 13

FIG. 14

FIG. 15

## INTERNATIONAL SEARCH REPORT

International application No.

PCT/JP2014/080253

A. CLASSIFICATION OF SUBJECT MATTER
*C23C16/40(2006.01)i, C03C17/245(2006.01)i*

According to International Patent Classification (IPC) or to both national classification and IPC

B. FIELDS SEARCHED

Minimum documentation searched (classification system followed by classification symbols)
C23C16/40, C03C17/245

Documentation searched other than minimum documentation to the extent that such documents are included in the fields searched
Jitsuyo Shinan Koho          1922–1996    Jitsuyo Shinan Toroku Koho    1996–2015
Kokai Jitsuyo Shinan Koho    1971–2015    Toroku Jitsuyo Shinan Koho    1994–2015

Electronic data base consulted during the international search (name of data base and, where practicable, search terms used)
JSTPlus/JMEDPlus/JST7580(JDreamIII)

C. DOCUMENTS CONSIDERED TO BE RELEVANT

| Category* | Citation of document, with indication, where appropriate, of the relevant passages | Relevant to claim No. |
|---|---|---|
| A | WO 2013/008894 A1 (Asahi Glass Co., Ltd.), 17 January 2013 (17.01.2013), claims 1 to 5; Mode for carrying out the invention (Family: none) | 1–12 |
| A | JP 2005-119920 A (Asahi Glass Co., Ltd.), 12 May 2005 (12.05.2005), claims 1 to 9; examples (Family: none) | 1–12 |
| A | JP 8-176826 A (Mitsubishi Electric Corp.), 09 July 1996 (09.07.1996), claims 1 to 19; examples & US 5776254 A            & KR 10-0203000 B | 1–12 |

| ☒ | Further documents are listed in the continuation of Box C. | ☐ | See patent family annex. |
|---|---|---|---|

| * | Special categories of cited documents: |
|---|---|
| "A" | document defining the general state of the art which is not considered    to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 05 February 2015 (05.02.15) | 24 February 2015 (24.02.15) |

| Name and mailing address of the ISA/ Japan Patent Office 3-4-3,Kasumigaseki,Chiyoda-ku, Tokyo 100-8915,Japan | Authorized officer

Telephone No. |
|---|---|

Form PCT/ISA/210 (second sheet) (July 2009)

**INTERNATIONAL SEARCH REPORT**

| International application No. |
| --- |
| PCT/JP2014/080253 |

C (Continuation).  DOCUMENTS CONSIDERED TO BE RELEVANT

| Category* | Citation of document, with indication, where appropriate, of the relevant passages | Relevant to claim No. |
| --- | --- | --- |
| A | WO 2011/013719 A1  (Asahi Glass Co., Ltd.), 03 February 2011 (03.02.2011), claims 1 to 8; Mode for carrying out the invention & EP 2461372 A1        & US 2012/0118362 A1 & CN 102473742 A        & KR 10-2012-0036976 A | 1-12 |
| A | JP 2004-507430 A  (Pilkington, PLC), 11 March 2004 (11.03.2004), claims 1 to 27; paragraph of Disclosure of Invention & WO 2002/018287 A1      & US 2004/0028911 A1 & EP 1315681 A | 1-12 |
| A | JP 2002-509516 A  (Glaverbel), 26 March 2002 (26.03.2002), claims 1 to 26; examples & WO 1999/048828 A1      & EP 1295856 A1 & US 2002/0182421 A1 | 1-12 |
| A | JP 2008-164680 A  (Canon Inc.), 17 July 2008 (17.07.2008), examples & EP 1939654 A1           & US 2008/0158674 A1 | 1-12 |

Form PCT/ISA/210 (continuation of second sheet) (July 2009)

**EP 3 072 991 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004507430 T
- JP 2002509516 T
- JP 2013238795 A
- JP 2014075636 A

**Non-patent literature cited in the description**

- **YOSHITAKE MASUDA ; KAZUMI KATO.** *Chem. Mater.,* 2008, vol. 20, 1057-1063